# EUROPEAN PATENT APPLICATION

(11) **EP 2 369 512 A1**
(43) Date of publication of application: **28.09.2011**
(21) Application number: 11001275.4
(22) Date of filing: 16.02.2011
(51) Int. Cl.: G06F 17/50

(54) **Computer assisted method and apparatus fo information technology infrastructure architecture design**

(30) Priority: 16.02.2010 US 706396
(71) Applicant: Accenture Global Services Limited, Dublin 4 (IE)
(72) Inventor: Brown, Alan, Dunton Bassett Leicestershire (GB)
(74) Representative: Müller-Boré & Partner Patentanwälte

(57) **Abstract**

Methods, computer-readable media, and apparatuses support the design and building of an information technology infrastructure. Build information may be extracted from an architecture diagram so that an automation engine can build and configure the infrastructure solution. The architecture diagram contains custom property lists that are associated with corresponding infrastructure components. Build data is then generated from the architecture diagram so that the automation engine can build a specified information technology infrastructure. The architecture diagram may represent each infrastructure component with an icon that is selected from a collection of icons, where each icon has a custom property template. Configuration data is populated in entries of the custom property template in accordance with the associated infrastructure component. Build data may be verified by determining whether different custom property lists in an architecture diagram are consistent and may be passed to the automation engine only when an approval indication is received.

## Description

### BACKGROUND

Information technology (IT) typically deals with the use of electronic computers and computer software to convert, store, protect, process, transmit, and securely retrieve information. The design and building of an IT infrastructure is an important objective of information technology.

Building an information technology (IT) infrastructure is typically a multi-stage effort. A network architect first draws an architecture diagram of the infrastructure with components, *e.g*., switches, routers, servers, and firewalls and the interconnectivity between the components. The architecture also connects peripheral components to network facilities, *e.g*., local area networks and the Internet. The architect may also provide commentary and describe characteristics of the components and connectivity in a text file or a build sheet. The diagram and/or commentary often form the basis of an architecture document that is presented to a network administrator in order to build IT infrastructure. The network administrator subsequently uses the information from the architecture document to build the IT infrastructure. The network administrator then enters the information into a web front-end or spreadsheet so that a build tool can configure specified components in the IT infrastructure.

The design, operation, maintenance and management of an IT infrastructure often present formidable challenges to an organization. The traditional practice of building an IT infrastructure is typically a multi-stage process that involves the transfer of information between different people having different job responsibilities. Consequently, the time to realize or modify an IT infrastructure may be longer than desired.

### BRIEF SUMMARY

Aspects of the invention provide methods, apparatuses, and computer-readable media for designing and building an information technology (IT) infrastructure. With one aspect, operation assumes characteristics similar to computer-aided design (CAD) and computer-aided manufacturing (CAM). IT infrastructure build information is extracted from a Microsoft Visio® diagram. An automation engine then uses the extracted information to build and configure the infrastructure solution as per the architecture diagram.

With another aspect of the invention, an architecture diagram contains custom property lists that are associated with each infrastructure component. Build data is then generated from the architecture diagram in order to build a specified information technology (IT) infrastructure. The architecture diagram may represent each infrastructure component with an icon that is selected from a collection of icons, where each icon has an associated custom property template. Configuration data is received for entries in the custom property template in accordance with the associated infrastructure component.

With another aspect of the invention, build data is verified by determining whether different custom property lists in an architecture diagram are consistent.

With another aspect of the invention, build data is passed to an automation engine only when an approval indication is received.

### BRIEF DESCRIPTION OF THE DRAWINGS

Aspects of the invention are illustrated by way of example and not limited in the accompanying figures in which like reference numerals indicate similar elements and in which:

Figure 1 shows a computer system used in a system for designing and building an IT infrastructure in accordance with an embodiment of the invention.

Figure 2 shows a system for building an infrastructure solution in accordance with an embodiment of the invention.

Figure 3 shows a flow diagram for building an infrastructure solution in accordance with an embodiment of the invention.

Figure 4 shows a system for building a specified infrastructure in accordance with an embodiment of the invention.

Figure 5 shows an exemplary architecture diagram for an infrastructure solution in accordance with an embodiment of the invention.

Figure 6 shows exemplary custom properties of a firewall in accordance with an embodiment of the invention.

Figure 7 shows exemplary custom properties of a server in accordance with an embodiment of the invention.

Figure 8 shows exemplary build data for building an infrastructure solution in accordance with an embodiment of the invention.

Figure 9 shows additional exemplary build data for building an infrastructure solution in accordance with an embodiment of the invention.

Figure 10 shows additional exemplary build data for building an infrastructure solution in accordance with an embodiment of the invention.

### DETAILED DESCRIPTION

Embodiments support designing and building an information technology (IT) infrastructure. With one aspect, operation assumes characteristics similar to computer-aided design (CAD) and computer-aided manufacturing (CAM). IT infrastructure design information is extracted from a Microsoft Visio® diagram. An automation engine uses the extracted information to build and configure the infrastructure solution as per the diagram. Operations documents may also be produced

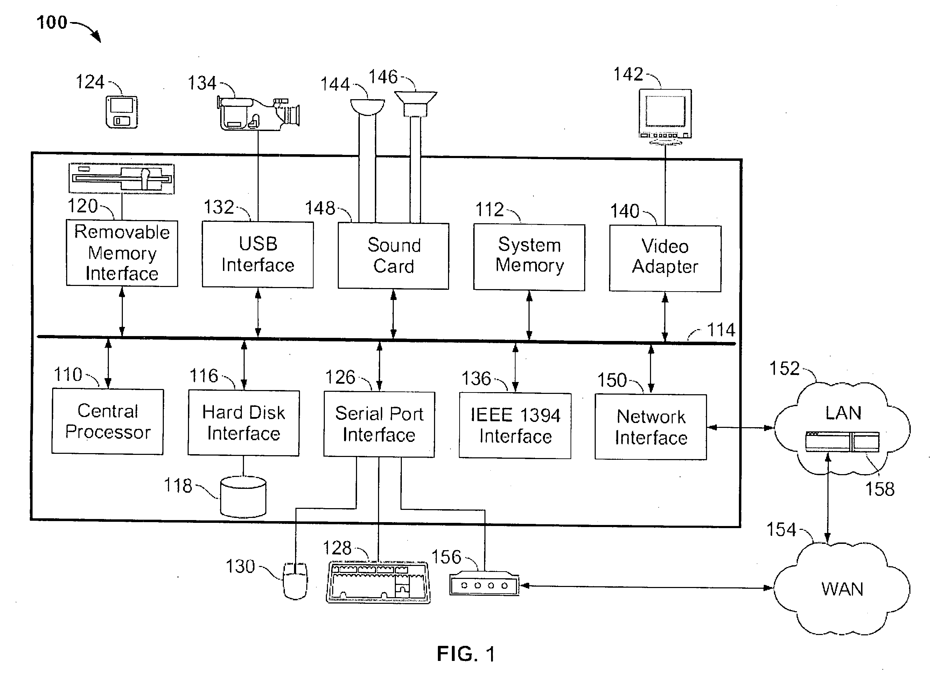

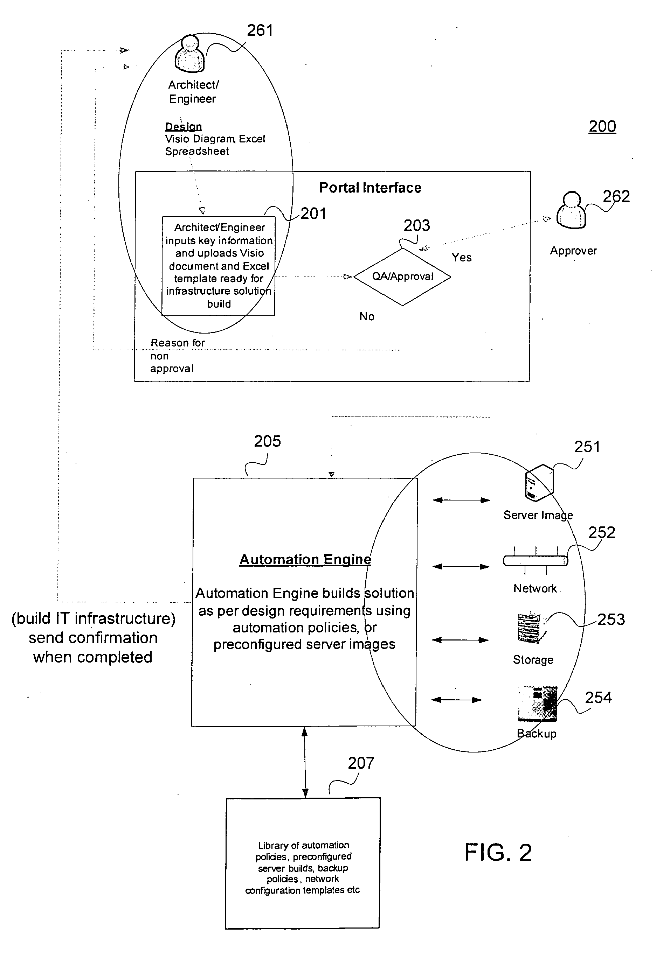

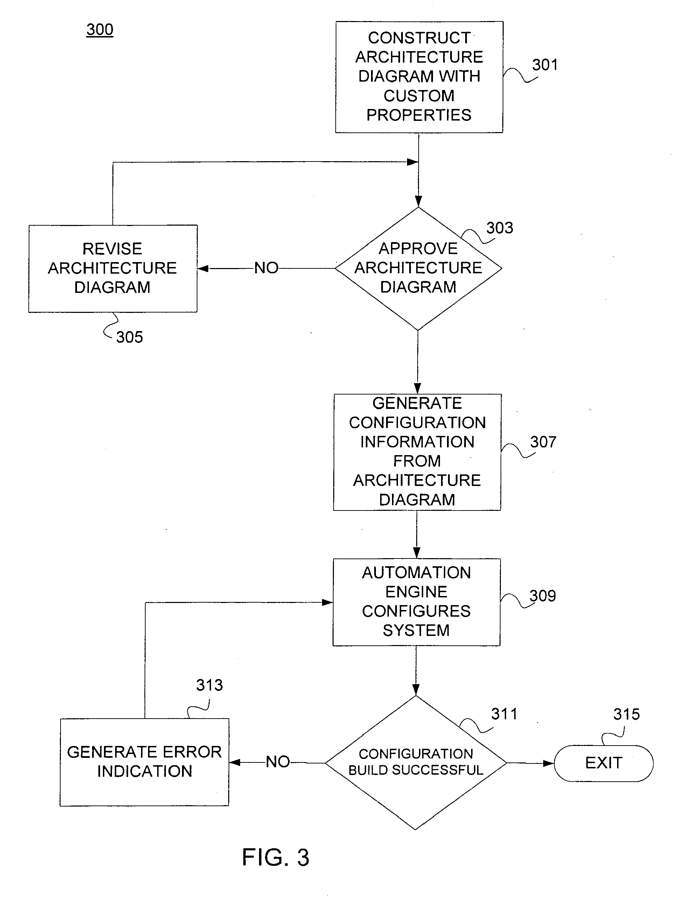

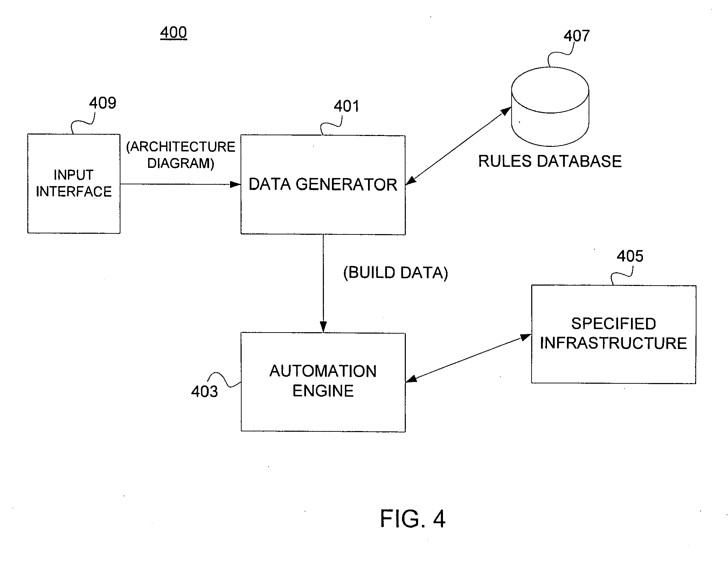

Elements of the present invention may be implemented with computer systems, such as the system 100 shown in Figure 1. System 100 may support a system (*e.g*., systems 200 and 400 as shown in Figures 2 and 4, respectively) and execute a process (*e.g*. process 300 as shown in Figure 3) to design and build an information technology (IT) infrastructure in accordance with aspects for the invention as disclosed herein.

Computer 100 includes a central processor 110, a system memory 112 and a system bus 114 that couples various system components including the system memory 112 to the central processor unit 110. System bus 114 may be any of several types of bus structures including a memory bus or memory controller, a peripheral bus, and a local bus using any of a variety of bus architectures. The structure of system memory 112 is well known to those skilled in the art and may include a basic input/output system (BIOS) stored in a read only memory (ROM) and one or more program modules such as operating systems, application programs and program data stored in random access memory (RAM).

Computer 100 may also include a variety of interface units and drives for reading and writing data. In particular, computer 100 includes a hard disk interface 116 and a removable memory interface 120 respectively coupling a hard disk drive 118 and a removable memory drive 122 to system bus 114. Examples of removable memory drives include magnetic disk drives and optical disk drives. The drives and their associated computer-readable media, such as a floppy disk 124 provide nonvolatile storage of computer readable instructions, data structures, program modules and other data for computer 100. A single hard disk drive 118 and a single removable memory drive 122 are shown for illustration purposes only and with the understanding that computer 100 may include several of such drives. Furthermore, computer 100 may include drives for interfacing with other types of computer readable media. A storage device (*e.g*., hard disk drive 118) may store predetermined values that are accessed when processing a process (*e.g*., process 300) when executing program data.

A user can interact with computer 100 with a variety of input devices. Figure 1 shows a serial port interface 126 coupling a keyboard 128 and a pointing device 130 to system bus 114. Pointing device 128 may be implemented with a mouse, track ball, pen device, or similar device. Of course one or more other input devices (not shown) such as a joystick, game pad, satellite dish, scanner, touch sensitive screen or the like may be connected to computer 100.

Computer 100 may include additional interfaces for connecting devices to system bus 114. Figure 1 shows a universal serial bus (USB) interface 132 coupling a video or digital camera 134 to system bus 114. An IEEE 1394 interface 136 may be used to couple additional devices to computer 100. Furthermore, interface 136 may configured to operate with particular manufacture interfaces such as FireWire developed by Apple Computer and i.Link developed by Sony. Input devices may also be coupled to system bus 114 through a parallel port, a game port, a PCI board or any other interface used to couple and input device to a computer.

Computer 100 also includes a video adapter 140 coupling a display device 142 to system bus 114. Display device 142 may include a cathode ray tube (CRT), liquid crystal display (LCD), field emission display (FED), plasma display or any other device that produces an image that is viewable by the user. Additional output devices, such as a printing device (not shown), may be connected to computer 100.

Sound can be recorded and reproduced with a microphone 144 and a speaker 166. A sound card 148 may be used to couple microphone 144 and speaker 146 to system bus 114. One skilled in the art will appreciate that the device connections shown in Figure 1 are for illustration purposes only and that several of the peripheral devices could be coupled to system bus 114 via alternative interfaces. For example, video camera 134 could be connected to IEEE 1394 interface 136 and pointing device 130 could be connected to USB interface 132.

Computer 100 can operate in a networked environment using logical connections to one or more remote computers or other devices, such as a server, a router, a network personal computer, a peer device or other common network node, a wireless telephone or wireless personal digital assistant. Computer 100 includes a network interface 150 that couples system bus 114 to a local area network (LAN) 152. Networking environments are commonplace in offices, enterprise-wide computer networks and home computer systems.

A wide area network (WAN) 154, such as the Internet, can also be accessed by computer 100. Figure 1 shows a modem unit 156 connected to serial port interface 126 and to WAN 154. Modem unit 156 may be located within or external to computer 100 and may be any type of conventional modem such as a cable modem or a satellite modem. LAN 152 may also be used to connect to WAN 154. Figure 1 shows a router 158 that may connect LAN 152 to WAN 154 in a conventional manner.

It will be appreciated that the network connections shown are exemplary and other ways of establishing a communications link between the computers can be used. The existence of any of various well-known protocols, such as TCP/IP, Frame Relay, Ethernet, FTP, HTTP and the like, is presumed, and computer 100 can be operated in a client-server configuration to permit a user to retrieve web pages from a web-based server. Furthermore, any of various conventional web browsers can be used to display and manipulate data on web pages.

The operation of computer 100 can be controlled by a variety of different program modules. Examples of program modules are routines, programs, objects, components, data structures, etc., that perform particular tasks or implement particular abstract data types. The present invention may also be practiced with other computer system configurations, including hand-held devices, multiprocessor systems, microprocessor-based or programmable consumer electronics, network PCS, minicomputers, mainframe computers, personal digital assistants and the like. Furthermore, the invention may also be practiced in distributed computing environments where tasks are performed by remote processing devices that are linked through a communications network. In a distributed computing environment, program modules may be located in both local and remote memory storage devices.

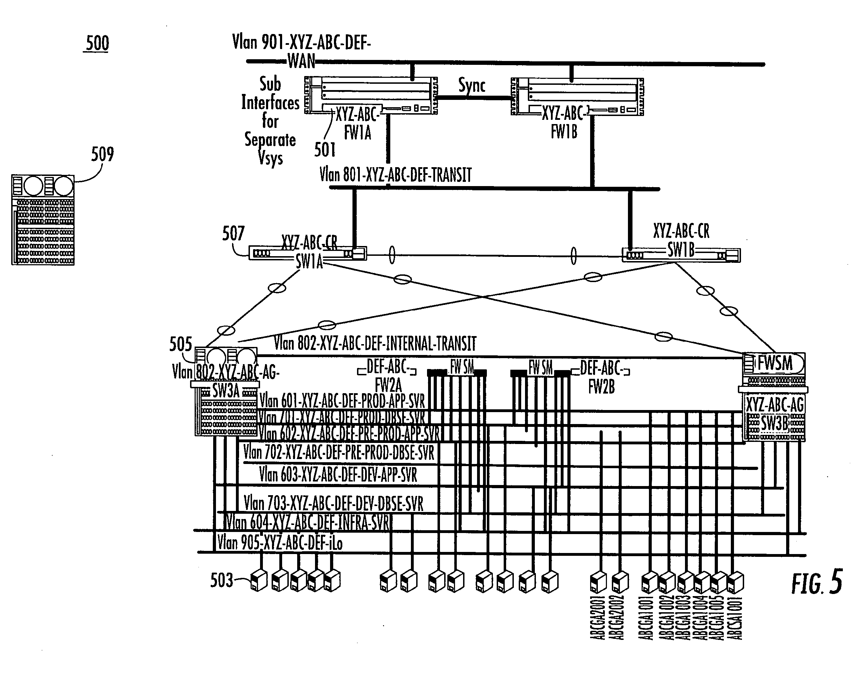

Figure 2 shows system 200 for building an infrastructure solution in accordance with an embodiment of the invention. System 200 may appear to have similar characteristics to architect 261 as a computer-aided design (CAD) or computer-aided manufacturing (CAM) system. System 200 extracts IT infrastructure design information from a Microsoft Visio® IT diagram in process 201. Architect 261 inputs the configuration of the specified IT infrastructure through a diagram, *e.g*., Microsoft Visio®. The diagram typically represents infrastructure components (*e.g*., server icon 251, network icon 252, storage device icon 253, and backup device icon 254) with icons that may be selected from an icon palette. In addition, a set of properties (characteristics) may be associated with each icon so that build information can be entered for each component by architect 261. Exemplary properties include: manufacturer, device name, product description, operating system, memory size, hard drive capacity, active directory route, IP address, configuration build, building, location, storage area network (SAN) storage size, storage device identification, VLAN IP address, VLAN connection, and WAN connection IP address. An exemplary architecture diagram with property lists will be discussed with Figures 5-7.

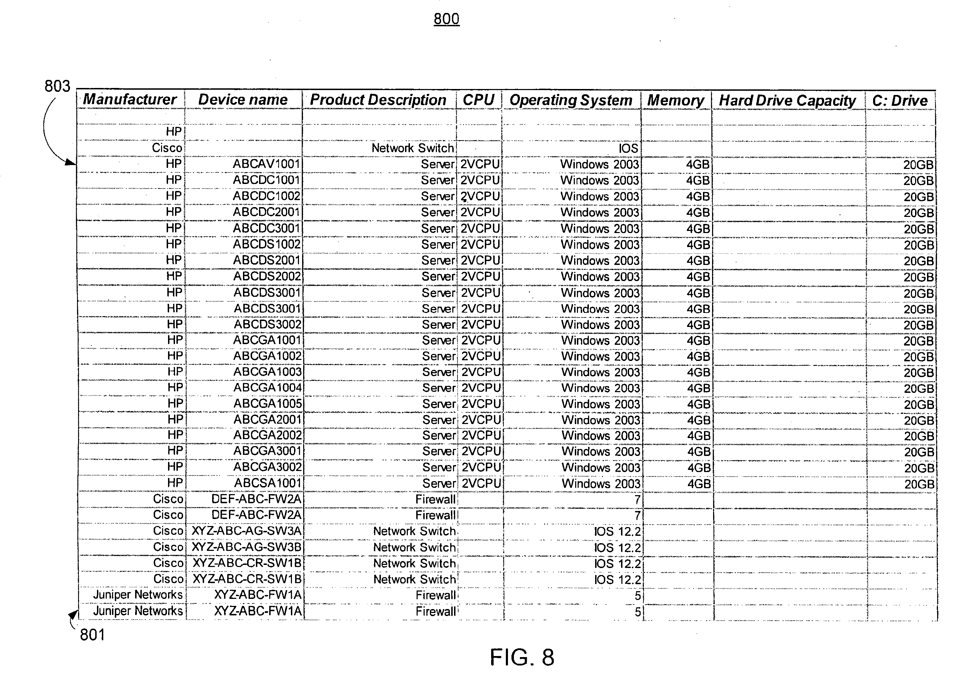

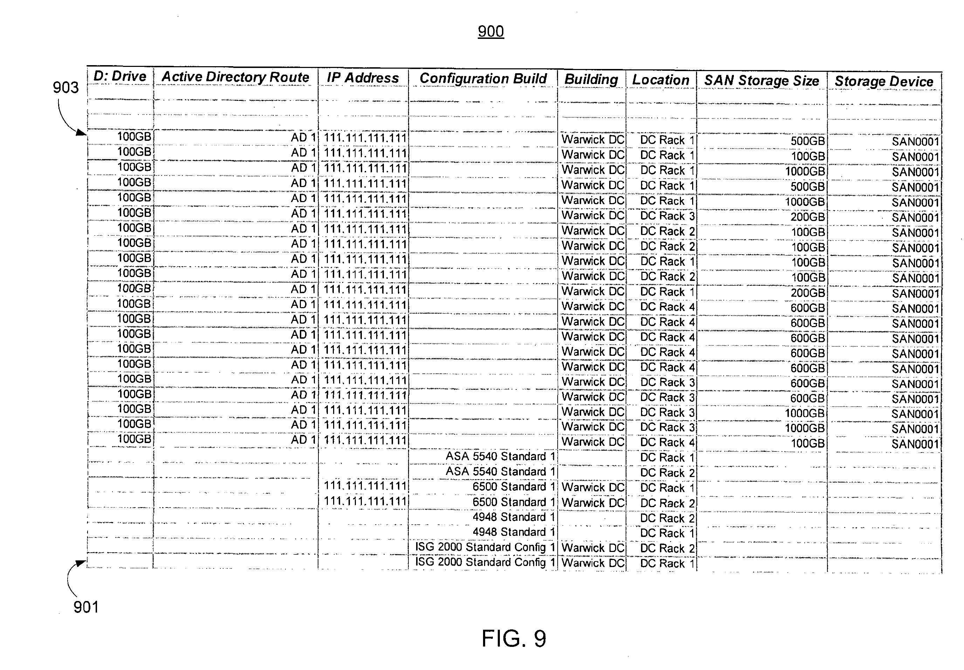

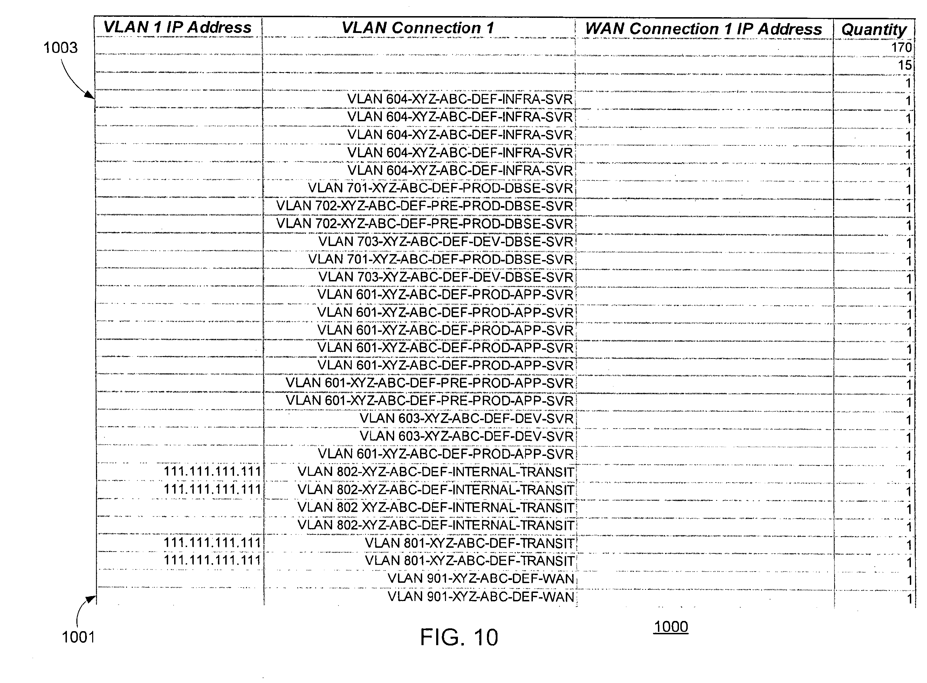

With some embodiments, build data is extracted from the architecture diagram in the form of a Microsoft Excel® spreadsheet as shown in Figures 8-10. With other embodiments, build data may be represented in a Microsoft XML file or text file.

With some embodiments, approver 262 reviews the architecture diagram with associated build information in step 203. If approver 262 approves the architecture diagram, build data is passed to automation engine 205. If approver 262 does not approve the architecture diagram, architect 261 is provided with reasons for not approving the diagram. The architecture diagram can be revised and resubmitted to process 201.

With some embodiments, automation engine 205 is implemented by an Opalis™ Integration Server, which functions as an IT process automation platform and is manufactured by Opalis Software Inc., headquartered in Toronto, Ontario The integration server supports automation fabric capabilities that enable a network administrator to rapidly integrate tools and automate IT services.

Automation engine 205 extracts and utilizes the build data to build and configure the infrastructure solution as per the architecture diagram. Operations documents may also be produced by automation engine 205 based on the build data. When automation engine 205 has completed building the IT infrastructure, configuration verification is sent to architect 261. However, if the build cannot be completed (*e.g*., a component is not available), notification is sent to the architect so that the problem can be resolved, automation engine 205 can then resume building the IT infrastructure.

Automation engine 205 may execute policies from library 207 and build routines that are typically performed by an engineer according to traditional systems. Pre-configured hardware images with property list templates may also improve standardization. This approach provides flexibility through the data collected from the requester to manipulate the automation policies and consequently the hardware configuration build, *e.g*., number of CPU's, disk protection, and the like.

Embodiments support designing and building an IT infrastructure. With one aspect, operation assumes characteristics similar to computer-aided design (CAD) and computer-aided manufacturing (CAM). IT infrastructure design information is extracted from a Microsoft Visio® diagram. An automation engine uses the extracted information to build and configure the infrastructure solution as per the diagram. Operations documents may also be produced

Figure 3 shows flow diagram 300 for building an infrastructure solution in accordance with an embodiment of the invention. In step 301, architect 261 constructs an architecture diagram in accordance with infrastructure requirements. The architecture diagram may include different formats, including Microsoft Visio® as shown in Figure 5. In addition to symbols representing infrastructure components and connectivity between components and connectivity to external network facilities, the architecture diagram may include custom property lists that are associated with the infrastructure components.

In step 303, approver 262 reviews the architecture diagram and approves diagram if it satisfies requirements for the desired IT infrastructure. If so, the architecture diagram is processed in step 307 so that build data can be extracted in a form that can be processed by an automation engine in step 309. The extracted build data may assume different formats, including Microsoft Excel®, EXtensible Markup Language (XML), or textual.

Referring to step 303, if approver 262 does not approve the submitted architecture diagram, approver 262 provides reasons for disapproving the diagram. Architect 261 than revises the architecture diagram to resolve the reasons and resubmits the diagram for approval.

With some embodiments, step 303 may be performed by a verification process that is executed by a computer, *e.g*., computer 100 as shown in Figure 1. The verification process may determine whether the property lists of different infrastructure components are consistent. For example, process 300 may detect a verification error if IP addresses for different components are the same or if a component does not have connectivity to any other component in the IT infrastructure.

Referring to step 309, automation engine 205 receives build data (*e.g*., configuration data represented in an Excel spreadsheet as shown Figure 8-10). Automation engine 205 ascertains that each infrastructure component is configured in accordance with the architecture diagram. For example, automation engine 205 determines whether a server is executing an updated operating system or whether a switch is connected to specified network facilities. In order to do so, automation engine 205 may communicate with different infrastructure components to obtain status information and to instruct an infrastructure component to configure in accordance with build information. If automation engine 205 successfully builds the IT infrastructure in step 311, process 300 is completed in step 315. However, if automation engine 205 detects a build error (*e.g*., a specified component is not installed) and if the build error cannot be autonomously resolved, automation engine 205 may generate an error indication in step 313 and suspend the build process until the error is resolved.

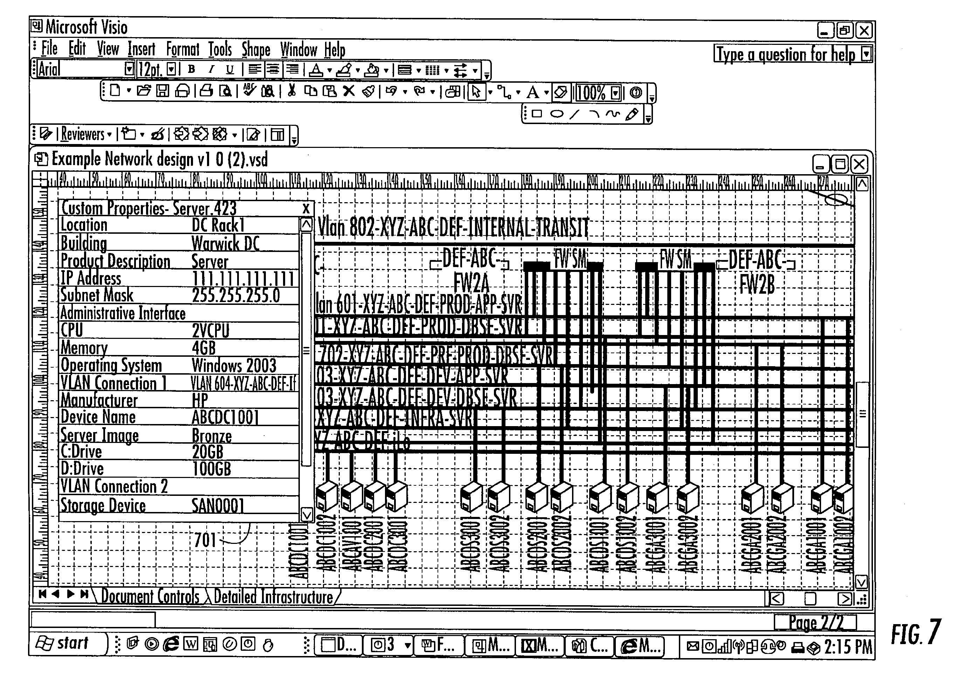

Figure 4 shows system 400 for building a specified infrastructure in accordance with an embodiment of the invention. Data generator 401 receives build information from an architecture diagram that may be constructed by architect 261. The architecture diagram typically represents each infrastructure component with an icon as shown in Figure 7. Data generator 401 processes the architecture diagram to extract build data and passes it to automation engine 403 if an approval indication is received, *e.g*., through input interface 409. Automation engine uses the build data to configure components in IT infrastructure 405 and/or verify that the components are properly configured.

With some embodiments, data generator 401 verifies that the architecture document is consistent with rules contained in rules database 407. If not, data generator may provide an error indicator and require that the error be resolved before passing the build data to automation engine 403.

Figure 5 shows exemplary architecture diagram 500 for an infrastructure solution in accordance with an embodiment of the invention. Diagram 500 includes different component types (*e.g*., server 503, switch 505, switch 507, and firewall 501) that may be interconnected with each other and connected to external network facilities. Architect 261 typically constructs diagram 500 by selecting an icon (*e.g*., icon 509) from a palette (not shown), positioning the icon, and connecting the icon to other icons. In addition, the icon may have a corresponding custom properties list that the architect populates with configuration data to reflect the desired configuration. Different types of infrastructure components may have different custom property templates. For example, the version of the operating system is typically relevant for a server but not for a switch.

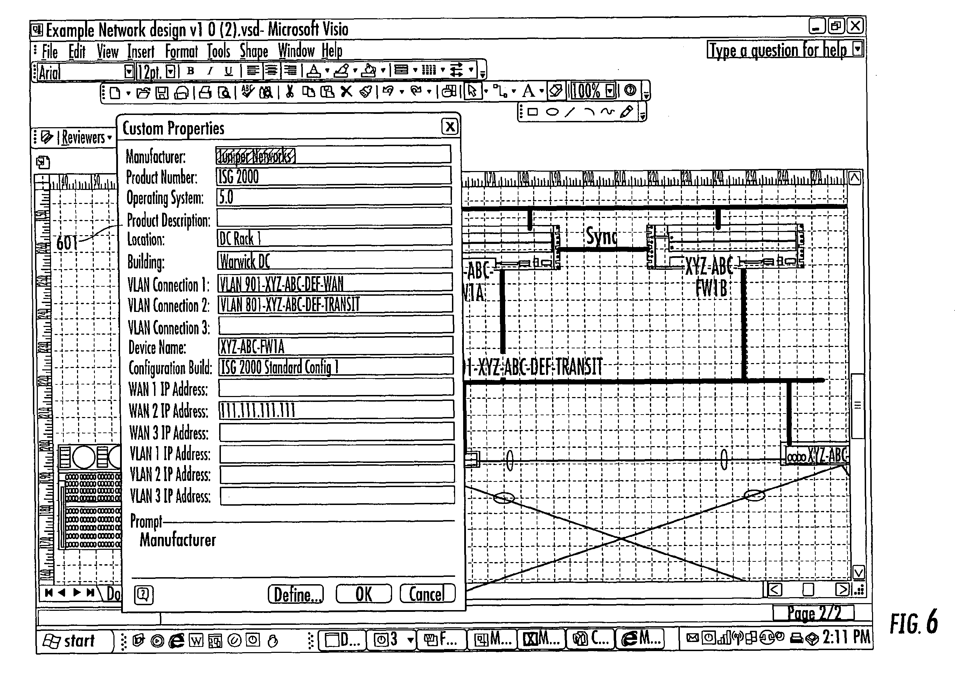

Figures 6 and 7 show exemplary custom property lists 601 and 701 of firewall 501 and server 503, respectively, in accordance with an embodiment of the invention. Property lists 601 and 701 are based on corresponding custom property templates that are populated with configuration data. If there is a modification in the IT infrastructure, the configuration data can be changed accordingly and presented to automation engine 403 to update IT infrastructure 405.

Figures 8, 9, and 10 show exemplary build data 800, 900, and 1000, respectively, for building an infrastructure solution in accordance with an embodiment of the invention. The exemplary build data is derived from architecture diagram 500 by extracting configuration information from custom property lists in diagram 500 (not explicitly shown in Figure 5). A custom property list is typically accessed for display and data entry by right clicking on the corresponding infrastructure component.

Because of the amount of configuration data in a custom property list, the extracted build data is illustrated in multiple figures, although the data is typically represented in one spreadsheet. For example, build data for server 503 and firewall 501 are shown in entries 803, 903, and 1003 and entries 801, 901, and 1001, respectively.

.As can be appreciated by one skilled in the art, a computer system with an associated computer-readable medium containing instructions for controlling the computer system may be utilized to implement the exemplary embodiments that are disclosed herein. The computer system may include at least one computer such as a microprocessor, a cluster of microprocessors, a mainframe, and networked workstations.

While the invention has been described with respect to specific examples including presently preferred modes of carrying out the invention, those skilled in the art will appreciate that there are numerous variations and permutations of the above described systems and techniques that fall within the spirit and scope of the invention as set forth in the appended claims.
The present application may also refer to the following items:
Item 1: A computer-assisted method comprising:
   obtaining, by a computer, an architecture diagram of an infrastructure solution, the architecture diagram including a first infrastructure component;
   associating, by the computer, a first custom property list with the first infrastructure component;
   generating, by the computer, build data from the first custom property list; and
   building, by the computer, a specified infrastructure from the build data.
Item 2: The method of item 1, wherein the architecture diagram includes a second infrastructure component, the method further comprising:
   incorporating a second custom property list associated with the second infrastructure component into the build data.
Item 3: The method of any one of the preceding items, further comprising:
   when an approval indication is received, passing the build data to build the specified infrastructure.
Item 4: The method of any one of the preceding items, further comprising:
   when a disapproval indication is received, providing a reason indication; and
   subsequently receiving an updated architecture diagram.
Item 5: The method of any one of the preceding items, further comprising:
   providing a collection of icons, each icon representing an infrastructure component type and having an associated custom property template; and
   obtaining the architecture diagram, the architecture diagram based on the collection of icons.
Item 6: The method of any one of the preceding items, further comprising:
   inserting configuration data for the first infrastructure component into the associated custom property template, wherein the configuration data characterizes the first infrastructure component in the specified infrastructure.
Item 7: The method of any one of the preceding items, further comprising:
   generating an error indication when the specified infrastructure cannot be completed; and
   resume building the specified infrastructure when a resolution indication is received.
Item 8: The method of any one of the preceding items, further comprising:
   verifying the build data.
Item 9: The method of any one of the preceding items, further comprising:
   determining whether the first custom property list and the second property list are consistent.
Item 10: A computer-readable storage medium storing computer-executable instructions that, when executed, cause a processor to perform a method comprising:
   obtaining an architecture diagram of an infrastructure solution, the architecture diagram including a first infrastructure component;
   inserting a first custom property list with the first infrastructure component;
   generating build data from the first custom property list; and
   configuring the first infrastructure component in accordance with the build data.
Item 11: The computer-readable medium of item 10, wherein the method further comprises:
   incorporating a second custom property list associated with the second infrastructure component into the build data.
Item 12: The computer-readable medium of items 10 or 11, wherein the method further comprises:
   building a specified infrastructure from the build data.
Item 13: The computer-readable medium of any one of items 10 to 12, wherein the method further comprises:
   when an approval indication is received, passing the build data to build the specified infrastructure.
Item 14: The computer-readable medium of any one of items 10 to 13, wherein the method further comprises:
   when a disapproval indication is received, providing a reason indication; and
   subsequently receiving an updated architecture diagram.
Item 15: The computer-readable medium of any one of items 10 to 14, wherein the method further comprises:
   providing a collection of icons, each icon representing an component type and having an associated custom property template; and
   obtaining the architecture diagram, the architecture diagram based on the collection of icons.
Item 16: The computer-readable medium of any one of items 10 to 15, wherein the method further comprises:
   generating an error indication when the specified infrastructure cannot be completed; and
   resume building the specified infrastructure when a resolution indication is received.
Item 17: The computer-readable medium of any one of items 10 to 16, wherein the method further comprises:
   verifying that the build data is consistent.
Item 18: The computer-readable medium of any one of items 10 to 17, wherein the method further comprises:
   determining whether the first custom property list and another property list are consistent, the other property list associated with a different infrastructure component.
Item 19: An apparatus comprising:
   a data generator configured to:
      obtain an architecture representation of an infrastructure solution, the architecture representation including a first infrastructure component;
      associate a first custom property list with the first infrastructure component; and
      generate build data from the first custom property list; and automation engine configured to:
         receive the build data from the data generator; and
         build a specified infrastructure from the build data.
Item 20: An apparatus of item 19, the architecture representation including a second infrastructure component, and the data generator further configured to incorporate a second custom property list associated with the second infrastructure component into the build data.
Item 21: The apparatus of items 19 or 20, the data generator further configured to pass the build data to build the specified infrastructure when an approval indication is received.
Item 22: The apparatus of any one of items 19 to 21, the data generator further configured to:
   send a reason indication when a disapproval indication is received; and
   subsequently provide an updated architecture representation to the automation engine.
Item 23: The apparatus of any one of items 19 to 22, the data generator further configured to:
   display a collection of icons, each icon representing an infrastructure component type and having an associated custom property template; and
   send the architecture representation to the automation engine, wherein the architecture representation is based on the collection of icons.
Item 24: The apparatus of any one of items 19 to 23, the automation engine further configured to:
   generate an error indication when the specified infrastructure cannot be completed; and
   resume building the specified infrastructure when a resolution indication is received.
Item 25: The apparatus of any one of items 19 to 24, further comprising a memory device storing a set of rules, the data generator configured to verify that the first custom property list and the second custom property list are consistent based on the set of rules.
Item 26: An apparatus comprising:
   a memory; and
   a processor configured to retrieve instructions from the memory and to perform:
      obtaining an architecture representation of an infrastructure solution, the architecture representation including a first infrastructure component;
      associating, a first custom property list with the first infrastructure component;
      generating build data from the first custom property list; and
      building a specified infrastructure from the build data.
   An architecture diagram may be a specific example of an architecture representation.

## Claims

1. A computer-assisted method comprising:
obtaining, by a computer, an architecture diagram of an infrastructure solution, the architecture diagram including a first infrastructure component;
associating, by the computer, a first custom property list with the first infrastructure component;
generating, by the computer, build data from the first custom property list; and
building, by the computer, a specified infrastructure from the build data.

2. The method of claim 1, wherein the architecture diagram includes a second infrastructure component, the method further comprising:
incorporating a second custom property list associated with the second infrastructure component into the build data.

3. The method of claims 1 or 2, further comprising:
when an approval indication is received, passing the build data to build the specified infrastructure, or
further comprising:
when a disapproval indication is received, providing a reason indication; and subsequently receiving an updated architecture diagram.

4. The method of any one of the preceding claims, further comprising:
providing a collection of icons, each icon representing an infrastructure component type and having an associated custom property template; and
obtaining the architecture diagram, the architecture diagram based on the collection of icons, and/or
further comprising:
inserting configuration data for the first infrastructure component into an associated custom property template, wherein the configuration data characterizes the first infrastructure component in the specified infrastructure.

5. The method of any one of the preceding claims, further comprising:
generating an error indication when the specified infrastructure cannot be completed; and
resume building the specified infrastructure when a resolution indication is received.

6. The method of any one of the preceding claims, further comprising:
verifying the build data, and/or
further comprising:
determining whether the first custom property list and the second property list are consistent.

7. A computer-readable storage medium storing computer-executable instructions that, when executed, cause a processor to perform a method comprising:
obtaining an architecture diagram of an infrastructure solution, the architecture diagram including a first infrastructure component;
inserting a first custom property list with the first infrastructure component;
generating build data from the first custom property list; and
configuring the first infrastructure component in accordance with the build data.

8. The computer-readable medium of claim 7, wherein the method further comprises:
incorporating a second custom property list associated with the second infrastructure component into the build data, and/or
wherein the method further comprises:
building a specified infrastructure from the build data.

9. The computer-readable medium of claims 7 or 8, wherein the method further comprises:
when an approval indication is received, passing the build data to build the specified infrastructure, or
wherein the method further comprises:
when a disapproval indication is received, providing a reason indication; and subsequently receiving an updated architecture diagram.

10. The computer-readable medium of any one of claims 7 to 9, wherein the method further comprises:
providing a collection of icons, each icon representing an component type and having an associated custom property template; and
obtaining the architecture diagram, the architecture diagram based on the collection of icons.

11. The computer-readable medium of any one of claims 7 to 10, wherein the method further comprises:
generating an error indication when the specified infrastructure cannot be completed; and
resume building the specified infrastructure when a resolution indication is received.

12. The computer-readable medium of any one of claims 7 to 11, wherein the method further comprises:
verifying that the build data is consistent, and/or
wherein the method further comprises:
determining whether the first custom property list and another property list are consistent, the other property list associated with a different infrastructure component.

13. An apparatus comprising:
a data generator configured to:
obtain an architecture representation of an infrastructure solution, the architecture representation including a first infrastructure component;
associate a first custom property list with the first infrastructure component; and
generate build data from the first custom property list; and
automation engine configured to:
receive the build data from the data generator; and
build a specified infrastructure from the build data.

14. An apparatus of claim 13, the architecture representation including a second infrastructure component, and the data generator further configured to incorporate a second custom property list associated with the second infrastructure component into the build data.

15. The apparatus of claims 13 or 14 , the data generator further configured to pass the build data to build the specified infrastructure when an approval indication is received, or
the data generator further configured to:
send a reason indication when a disapproval indication is received; and subsequently provide an updated architecture representation to the automation engine.

16. The apparatus of claim any one of claims 13 to 15, the data generator further configured to:
display a collection of icons, each icon representing an infrastructure component type and having an associated custom property template; and
send the architecture representation to the automation engine, wherein the architecture representation is based on the collection of icons.

17. The apparatus of any one of claims 13 to 16, the automation engine further configured to:
generate an error indication when the specified infrastructure cannot be completed; and
resume building the specified infrastructure when a resolution indication is received.

18. The apparatus of any one of claims 13 to 17, further comprising a memory device storing a set of rules, the data generator configured to verify that the first custom property list and the second custom property list are consistent based on the set of rules.

19. An apparatus comprising:
a memory; and
a processor configured to retrieve instructions from the memory and to perform:
obtaining an architecture representation of an infrastructure solution, the architecture representation including a first infrastructure component;
associating, a first custom property list with the first infrastructure component;
generating build data from the first custom property list; and
building a specified infrastructure from the build data.
